# EUROPEAN PATENT APPLICATION

(11) **EP 2 874 042 A1**
(43) Date of publication of application: **20.05.2015**
(21) Application number: 13192650.3
(22) Date of filing: 13.11.2013
(51) Int. Cl.: G06F 1/04, H03K 5/156, H03L 3/00, H03L 7/00

(54) **Oscillator buffer and method for calibrating the same**

(71) Applicant: Stichting IMEC Nederland, 5656 AE Eindhoven (NL)
(72) Inventor: Chillara, Vamshi Krishna, 3001 Leuven (BE); Liu, Yao-Hong, 3001 Leuven (BE); Staszewski, Robert Bogdan, 3001 Leuven (BE)
(74) Representative: Van Bladel, Marc

(57) **Abstract**

The present invention relates to a buffering circuit (21) for buffering an oscillator signal. The buffering circuit comprises
- a plurality of PMOS and NMOS transistor pairs connected in parallel, each pair having connected gate terminals and connected drain terminals forming an inverter circuit, each pair arranged for receiving via a direct coupling an oscillator signal at its gate terminal, each pair further being connected with an additional PMOS and NMOS transistor (P1, N1, P2, N2)
- a control circuit (4) arranged for receiving an output signal output by said inverter circuits, for deriving information on the DC level of said output signal and for adjusting a voltage transfer curve expressing a relationship between a voltage at the input and output of said buffering circuit, by switching on or off said additional PMOS and NMOS transistors based on said derived information

## Description

### Field of the invention

The present invention is generally related to the field of oscillators for use in e.g. wireless low-power applications.

### Background of the invention

Oscillators used in phase-locked-loops (PLLs) form an important part of transceivers encountered in the field of wireless low power applications. Ultra-low-power (ULP) transceivers enable short-range networks of autonomous sensor nodes for wireless personal area networks (WPANs), wireless body area networks (WBANs), Internet-of-things etc. A Phase Locked Loop (PLL) forms an essential block of such transceivers. Radio frequency (RF) PLLs for frequency synthesis and modulation however consume a significant share of the total transceiver power. Hence, in order to realize ULP WPAN radios the availability of highly power efficient PLLs, preferably in the sub-mW range, is highly desirable.

All-digital PLLs have been proposed to achieve savings in both area cost and power dissipation. Compared to analog PLLs, all-digital PLLs (ADPLLs) are preferred in nanoscale CMOS as they dramatically reduce the chip area and further offer benefits of programmability, capability of extensive self-calibrations and easy portability. In this way power-efficient wireless applications, like e.g. biomedical applications and wireless sensor networks, can be envisaged.

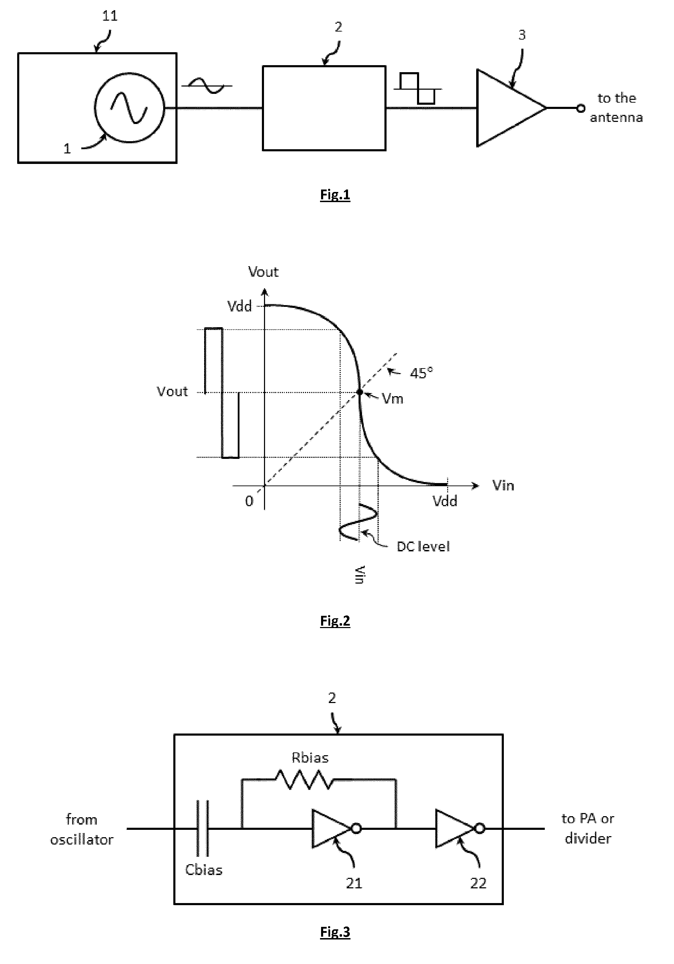

An LC-tank based oscillator is typically used within a phase-locked-loop (PLL) for frequency synthesis in wireless applications. The oscillation occurs at the resonance frequency of the LC tank. This frequency is corrected to the required value by a negative feedback configuration. As illustrated in Fig.1, instead of driving the power amplifier (PA) 3 or divider blocks directly by the oscillator 1, a buffer 2 is usually used to isolate the oscillator from the effects of varying load, referred to as load-pulling. Load-pulling changes the oscillator resonance frequency resulting in frequency deviations, before the PLL 11 restores the locked condition. Also, it allows the oscillator to operate in a current-limited regime with a low output swing. LC oscillators operating in a current limited regime are power efficient with an output swing much lower than the rail-to-rail level (i.e. VDD to GND). The oscillator buffer thus also serves to drive the power amplifier or divider circuits that warrant rail-rail swings. Note that the oscillator buffer is required even when the oscillator is not incorporated in a PLL and operates in an open loop configuration.

Digital inverters can act as power efficient buffers. They are constructed using at least one pair of complementary transistors, i.e. a p-channel and an n-channel transistor with their gate terminals and their drain terminals connected together. Process, voltage or temperature variations (commonly referred to as PVT variations) affect the circuit characteristics and hence its performance and power efficiency. Process variation is a term used to refer to a variation of fabrication parameters (doping concentration, length, width of transistor etc.) when designing an integrated circuit (i.e. a functional circuit). Process corners represent the extremes of these parameter variations within which the circuit must function correctly. A p-channel and n-channel transistor fabricated at these process corners may run slower or faster than specified and at lower or higher temperatures and voltages.

Digital inverter quality is measured using the Voltage Transfer Curve (VTC), which plots the inverter output voltage as a function of its input voltage. From such a graph, inverter parameters including noise tolerance, gain and operating logic levels can be obtained. Ideally, the VTC appears as an inverted step function, indicating precise and abrupt switching between an 'on' and an 'off' state. In real inverters, however, a gradual transition region exists. The VTC indicates that for a low input voltage, the circuit outputs a high voltage, whereas for high input voltage the output tapers off towards the low level. The slope of this transition region is a measure of quality : steep (close to infinity) slopes yield precise switching. The tolerance to noise can be measured by comparing the minimum input to the maximum output for each region of operation (on/off state).

To enable operation with low-input swings, the inverter should be biased at the point where the inverter gain is the highest (maximum sensitivity point Vₘ), see Fig.2. If the inverter is biased at a higher (or lower) voltage than this point, the inverter output might not reach maximum output swing, full-scale on the high level, VDD to low level, GND. Consequently, the subsequent stages the inverter drives might fail as the PMOS (or NMOS) transistor might not be turned on as required. Also, biasing at the maximum sensitivity point results in an output signal with a 50% duty cycle for a sinusoidal input; any voltage greater than this bias voltage gives a low output and vice versa.

As the DC level of the oscillator output is prone to process, voltage and temperature variations, this DC level may vary. Conventionally, a self-biased inverter is used as an oscillator buffer, which is AC-coupled to the oscillator output by means of a large coupling capacitor C_{bias}. Fig.3 provides an illustration. AC-coupling indicates that only an AC signal is passed from the preceding stage into the following stage, while the DC signal is blocked by a large decoupling capacitor. In other words, the DC level of the oscillator is not affecting the DC level at the buffer input. The DC level at the buffer input is fixed by a large resistor R_{bias} as follows. Since the resistor is connected to the gate of the NMOS and PMOS transistor of the inverter, no DC voltage drop occurs across the inverter. Thus, the resistor R_{bias} ensures a same DC level of the inverter input and output nodes. By properly sizing the PMOS and NMOS transistors, the maximum sensitivity point is ensured to lie at the intersection of the VTC and the "Vᵢₙ = Vₒᵤₜ" curve positioned at 45° (see Fig.2), where the buffer operates, thereby enabling low-input swing operation. Hence, in an AC-coupled self-biased inverter as in Fig.3, the VTC is fixed and defined by the inverter sizing such that the DC level fixed by R_{bias} corresponds to the maximum sensitivity point on the VTC of the buffer.

However, the passive components used in this approach do not scale down with advancements in semiconductor technology. Hence, such a solution occupies a large area leading to high system costs. Moreover, the large resistor R_{bias} used for biasing is a source of significant thermal noise, which couples into the oscillator output, thereby degrading its phase noise performance. Thus the oscillator needs to expend more current to maintain the required phase noise levels. Furthermore, the large decoupling capacitor introduces significant parasitics, thereby loading the output node of the oscillator. This increases the power consumption and reduces the maximum operable frequency of the oscillator. Thus a self-biased inverter used as a buffering circuit poses a serious challenge in scaling down the power consumption and area.

In the paper *"*A 915 MHz, Ultra-Low Power 2-Tone Transceiver With Enhanced Interference Resilience" (X.Huang et al., IEEE Journal Solid State Circuits, vol.47, no.12, December 2012, pp.3197-3207) an AC-coupled LO buffer is used to isolate the low-swing oscillator from the power amplifier. It uses passive components and hence does not scale with technology. Also, it needs additional biasing, adding to the total power consumption.

Consequently, there is a need for an oscillator buffer wherein the above-mentioned drawbacks of the prior art solutions are avoided or overcome.

### Summary of the invention

It is an object of embodiments of the present invention to provide for an inverter based oscillator buffer wherein the use of passive components is avoided. It is a further object to provide a method for calibrating the oscillator buffer.

The above objective is accomplished by the solution according to the present invention.

In a first aspect the invention relates to a buffering circuit for buffering an oscillator signal, said buffering circuit comprising
- a plurality of PMOS and NMOS transistor pairs connected in parallel, each pair having connected gate terminals and connected drain terminals forming an inverter circuit, each pair arranged for receiving via a direct coupling an oscillator signal at its gate terminal, each pair further being connected with an additional PMOS and NMOS transistor,
- a control circuit arranged for receiving an output signal output by said inverter circuits, for deriving information on the DC level of said output signal and for adjusting a voltage transfer curve expressing a relationship between a voltage at the input and output of said buffering circuit, by switching on or off said additional PMOS and NMOS transistors based on said derived information.

The proposed solution indeed allows for avoiding passive components. A DC coupling between the oscillator and the buffering circuit is possible. Variations in the DC level can be dealt with by providing a control circuit that receives at its input the buffer output signal and determines an indication of its DC level. Next the voltage transfer curve at the buffer input can be adjusted by appropriately switching the additional transistors in the circuit such that the DC-level at the buffer input and the maximum sensitivity point on the VTC are at the same voltage level.

In a preferred embodiment the control circuit is arranged for deriving said information on said DC level by averaging said output signal.

In an embodiment the inverter circuit is implemented in CMOS.

In an advantageous embodiment the transistor pairs of said plurality are sized such that they form binary weights. The gate widths of transistors belonging to different pairs then have a ratio that is a power of 2.

In a preferred embodiment the control circuit is arranged for adjusting the voltage transfer curve of said inverter circuit by generating code words and hence its output DC-level.

The invention also relates to a device comprising an oscillator and a buffering circuit as previously described.

Advantageously, said oscillator is a voltage controlled oscillator or a digitally controlled oscillator.

In one embodiment the device comprises a further buffer arranged for receiving the output signal of the preceding buffer circuit. This is especially useful when a large load is applied, as it allows reducing the size of the preceding buffer circuit.

In a preferred embodiment the oscillator of the device is part of a phase-locked loop.

In another aspect the invention relates to a method for calibrating a buffering circuit, comprising the steps of
- applying via a direct coupling an oscillator signal to a circuit comprising a plurality of PMOS and NMOS transistor pairs connected in parallel, each pair having connected gate terminals and connected drain terminals forming an inverter circuit, each pair arranged for receiving said oscillator signal at its gate terminal, each pair further being connected with an additional PMOS and NMOS transistor,
- deriving information on the DC level of an output signal output by said inverter circuits, and
- adjusting a voltage transfer curve expressing a relationship between a voltage at the input and output of said buffering circuit, by switching on or off said additional PMOS and NMOS transistors based on said derived information.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.

Fig.1 illustrates a conventional scheme wherein the oscillator of a PLL and a load are isolated by a buffer.

Fig.2 illustrates the determination of the maximum sensitivity point on a Voltage Transfer Curve (VTC).

Fig.3 illustrates a conventional self-biased inverter scheme.

Fig.4 illustrates the operational principle of a VTC tuneable buffer according to the invention.

Fig.5 illustrates the shifting of the Voltage Transfer Curve.

Fig.6 illustrates an embodiment of the buffer circuit according to the invention.

Fig.7 illustrates another embodiment of the buffer circuit according to the invention.

Fig.8 illustrates a detailed view on yet another embodiment of the buffer circuit according to the invention.

Fig.9 illustrates some simulation results of the proposed buffer circuit across process corners.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

Hereto, in the context of the present invention an AC coupled circuit refers to a circuit with the output of a preceding circuit connected to a succeeding circuit by means of a decoupling capacitor, thereby blocking the DC signal while allowing the AC signal to pass through. A DC coupled circuit refers to a circuit where two consecutive circuits are connected directly without any decoupling capacitor, thereby allowing both AC and DC signals to pass through.

Also in the context of the present invention, a DC level of a sinusoidal signal refers to the average value of the signal in one cycle. Stated otherwise, it is the level about which the sinusoidal wave oscillates.

In the present invention bulky passive components are avoided by providing a DC coupling of the oscillator output to the buffer. Depending on the input DC level (DC level of the sinusoidal signal from the oscillator), the VTC of the buffer is shifted to ensure operation at maximum sensitivity across process, voltage and temperature (PVT) variations. In this way, an area efficient low-power buffer is realized which can operate with low input swings over PVT variations. The oscillator used in this invention can be e.g. a Voltage Controlled Oscillator (VCO), a Digitally Controlled Oscillator (DCO) or an oscillator operating in an open loop configuration. Advantageously the oscillator may be part of a PLL.

In the proposed solution decoupling the capacitor C_{bias} and the biasing resistor R_{bias} is avoided and the oscillator output is connected directly to the buffer. Consequently, the variation in the DC level of the oscillator output affects the operation of the buffer. Thus, to ensure the oscillator buffer always operates at its maximum sensitivity point, it is proposed to shift its VTC so that the DC level of the oscillator output corresponds to the maximum sensitivity point of the buffer. A more detailed explanation is provided below.

As explained previously, operation at the maximum sensitivity point Vₘ of the inverter results in the maximum possible gain. Thus, a low-swing input signal can be boosted to rail-to-rail levels, i.e. VDD to GND. Operating at the maximum sensitivity point of the buffer also results in a buffer output with 50% duty cycle for a sinusoidal input, as the input sinusoidal signal has equal duration for voltages above and below its DC level, hence the output signal also has a 50% duty cycle. However, any input voltage Vᵢₙ greater than or lower than the input voltage value corresponding to maximum sensitivity point Vₘ results in an output voltage Vₒᵤₜ with (i) a low swing (amplitude) and (ii) a lower or a higher duty cycle, as the inverter does not operate in its linear region. The duty cycle of the output voltage will increase or decrease depending on whether the input DC level is smaller than or greater than the voltage corresponding to the maximum sensitivity point Vₘ. For example, a very low output swing is observed for input voltage Vᵢₙ having an average value close to zero or VDD. In case the DC-level of Vᵢₙ is close to VDD, the duty cycle of the output voltage is small, nearly 0. Similarly, if the DC-level of Vᵢₙ is close to zero, the duty cycle of the output voltage is, nearly 100%. The information on the duty cycle of the buffer output voltage is used for calibrating (shifting) the buffer's VTC along the X-axis to the desired position across PVT variations, assuring compensation for any variations in the input DC level of the buffer. Any calibration circuit that can monitor and detect deviation in a duty cycle of a signal may be used for this purpose.

In the solution of the invention a DC-coupled oscillator buffer is presented. The DC level at the buffer input is determined by the oscillator's output DC level. The oscillator can be, for example, a voltage controlled oscillator (VCO) or a digitally controlled oscillator (DCO). The buffer's VTC is shifted along the X-axis to ensure its maximum sensitivity point tracks the DC level of the oscillator output, which changes due to process, voltage and temperature variations. The invention further presents a technique for tuning the DC coupled oscillator buffer. A feedback loop is provided comprising a control circuit adapted for adjusting the DC level of the buffer output by changing the voltage transfer curve of the buffer. Thus, the proposed solution aims at tuning the VTC of the inverter to match the maximum sensitivity point with the DC level of the VCO/DCO output.

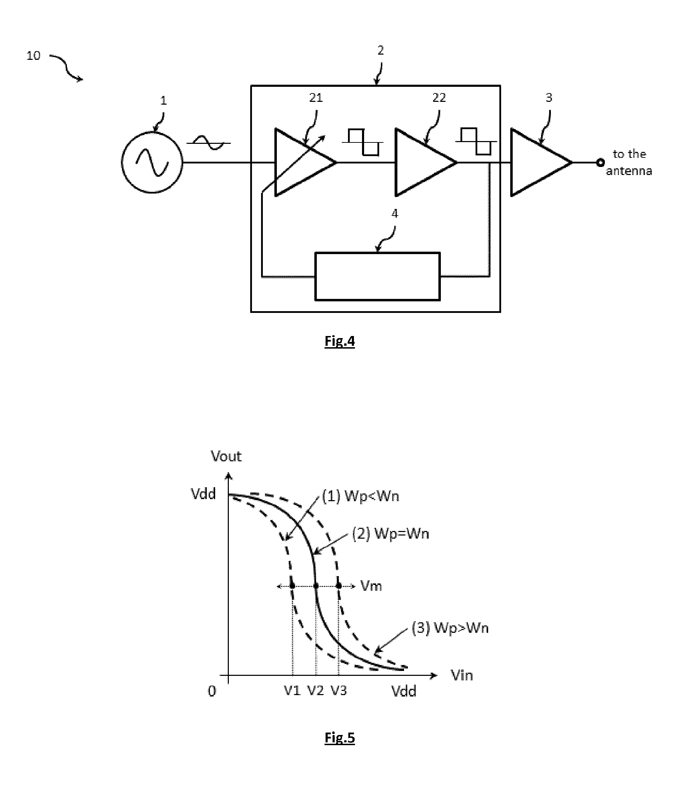

Fig.4 shows a block scheme of a device comprising an embodiment of the oscillator buffer according to the invention. The device 10 comprises an oscillator 1, the output of which is directly connected to the input of buffer 21. The buffer may be implemented as a CMOS inverter. The buffer output is in the embodiment of Fig.4 applied to an optional further buffer 22, which subsequently feeds its output to the power amplifier 3. Providing this additional buffer is beneficial in that it allows reducing the size of the first buffer when a large load needs to be driven.

A control circuit 4 is provided for shifting the buffer VTC to the required level. One possible way to realize this shift can be to detect the duty cycle of the buffer output by averaging the waveform to obtain the DC level. If for example the output voltage has an average value (i.e. DC level) greater than VDD/2, this indicates that its duty cycle is greater than 50 % (the duration of the positive waveform is longer than the negative waveform). This translates to an input DC level lower than the input voltage corresponding to the maximum sensitivity point Vₘ of the buffer. Hence, the control circuitry turns on more NMOS transistors to shift the VTC to the left, so that a 50% duty cycle of Vₒᵤₜ is achieved (i.e. the output voltage has an average value equal to VDD/2). Similarly, if the average is less than VDD/2, more PMOS transistors are enabled to ensure an output voltage Vₒᵤₜ with 50% duty cycle.

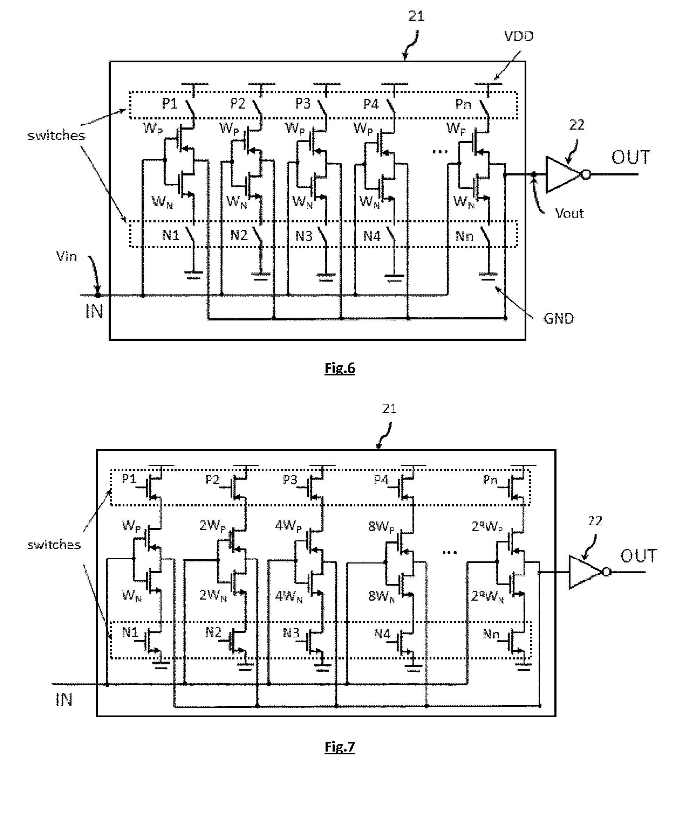

Fig.5 illustrates the VTC shifting for low-input swing operation of the buffer in order to track the input DC level across process variations. The VTC can be shifted by varying the overall ratio of the gate width of PMOS and NMOS transistors that form the buffer. The overall transistor ratio, denoted as Wₚ/Wₙ, represents the total ratio of the sizes (or gate width) of the PMOS and NMOS transistors forming the buffer. It is to be noted that since the transistor pairs are connected in parallel the sizes (gate widths) can simply be added. To this end, a set of complementary transistors (PMOS-NMOS) are connected in parallel to act as an inverter as shown in Fig.6. Each respective transistor of the complementary set is connected to supply rails, i.e. PMOS to VDD and NMOS to GND, via an additional PMOS and an additional NMOS transistor, respectively. Depending on the state of the additional transistor (on or off), the respective transistor of the complementary set is connected to VDD or GND. Thus, the additional transistors act as switches to connect or disconnect their respective transistor of the set of complementary transistors to VDD or GND, resulting in a change of the overall Wₚ/Wₙ ratio of the buffer and hence a shift of its VTC. The PMOS and NMOS switches may be controlled by different control signals, e.g. by digital code words P1 to Pn and N1 to Nn, respectively. This allows a different number of PMOS and NMOS transistors from the complementary sets to be connected to supply rails, thereby changing the ratio of PMOS and NMOS transistors comprised in buffer circuit 21. Changing this ratio shifts the VTC of the resulting buffering circuit along the X-axis. This way, the VTC of the DC-coupled oscillator buffer 21 can be shifted by digitally controlling the transistors ratio Wₚ/Wₙ of the inverter to cover PVT variations. More in detail, switching more PMOS transistors moves the VTC and hence its point of maximum sensitivity to the right along the X-axis, while switching more NMOS transistors causes the VTC and hence the maximum sensitivity point to shift to the left. As a change in the ratio between switched PMOS and NMOS transistors results in shifting the VTC along the X-axis, switching a number of equally sized PMOS and NMOS transistors does not affect (move) the VTC of the buffering circuit, as the overall transistor ratio Wₚ/Wₙ which determines the position of VTC, remains unchanged. Increasing this ratio moves the VTC towards VDD (right) and decreasing moves it towards GND (left). Fig.6 shows an example implementation of the oscillator buffer, where the transistors forming the complementary set have the same sizes, i.e. each NMOS transistor has a gate width of Wₙ and each PMOS transistor a gate width of Wₚ. Another possible implementation of the oscillator buffer is shown in Fig.7 where the PMOS/NMOS transistors are binary weighted.

The number of transistors and their gate width should be sized accordingly to account for PVT variations and the load to be driven. The variation in DC level of the oscillator output is estimated via circuit simulations across process corners representing the extremes of the parameter variations (such as doping concentrations, length, width etc.). The extremes represent the case when all the process variations either deviate towards a transistor with reduced currents (slow corner) or increased currents (fast corner). The number and width of the switchable PMOS and NMOS transistors is then chosen to cover this variation with an extra margin (e.g. 5%). For example, in Fig. 6, when the n-bit control word for both the PMOS and NMOS switches is (0000....1), all the switches except for Pn and Nn are off. Hence, only the transistors connected to these switches comprise the buffer leading to an overall transistor ratio Wₚ/Wₙ. When the code words for PMOS and NMOS switches are (1100...1) and (1000...0), then the switches P1, P2, Pn and N1 are on. Hence the transistor ratio in this case is increased to 3Wₚ/Wₙ. Similarly, if the code words for PMOS and NMOS switches are (1000...1) and (1100...1), the transistor ratio is decreased to 2Wₚ/3Wₙ.

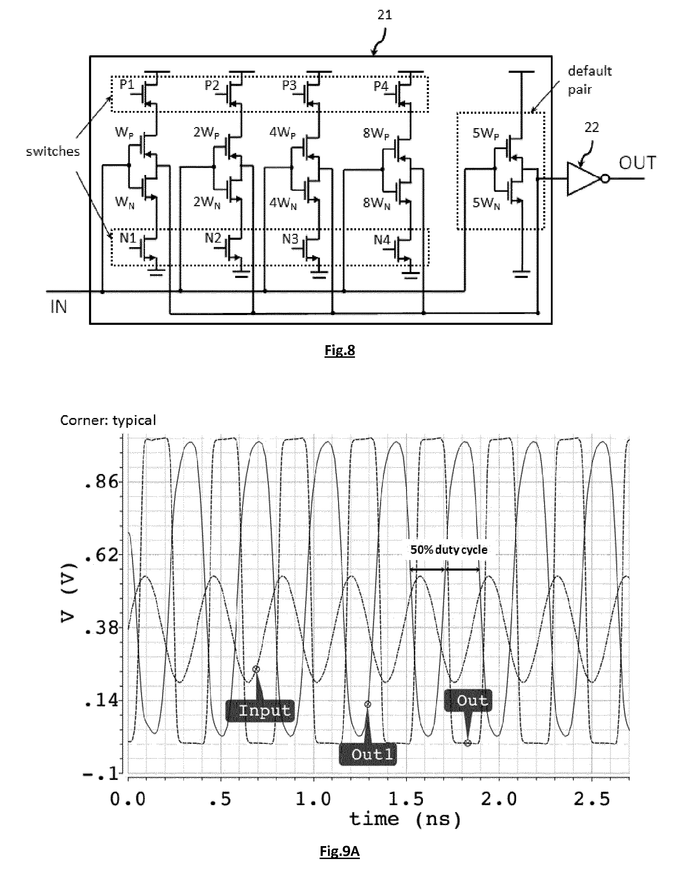

Fig.8 shows the schematic of an embodiment of the proposed buffer with digitally tuneable VTC. The buffer comprises a default complementary pair of PMOS and NMOS transistor and four PMOS and NMOS transistors with binary weighted widths serving as the tuneable inverters. In this implementation, the default pair is always connected to supply rails and thus provides an initial value of buffer's Wₚ/Wₙ ratio. The binary weighted transistors are controlled by a single 5-bit digital word. When the input code is "00000", none of the additional transistors are connected, but the default complementary pair. This default pair is sized at five times that of the smallest switchable pair to drive the subsequent load while operating at the maximum sensitivity point for an input DC level corresponding to the typical corner. The MSB of the 5-bit buffer control determines whether PMOS or NMOS need to be turned on, while the 4 LSB bits determine how many of those transistors are turned on. For example, for a single control word (11010), the MSB '1' indicates that PMOS transistors should be on and the 4-LSB '1010' indicate that switches P2 and P4 are on. Similarly, for a single control word (01010), the MSB '0' indicates that NMOS transistors should be on and the 4-LSB '1010' indicate that switches N2 and N4 are on. This is just one possible implementation of the way the ratio Wₚ/Wₙ is controlled and the skilled person will readily find alternative implementations. It is possible for example to have separate 4-bit control words for PMOS and NMOS transistors rendering more flexibility as illustrated in Fig. 6 and Fig. 7. By monitoring the duty cycle of the buffer output signal the control code (5-bit binary for e.g. 10100) that shifts the VTC to the desired position is generated. At the optimal biasing point, the duty cycle of the oscillator output is 50%. The precision with which the VTC can be shifted, is determined by the smallest possible change in the ratio Wₚ/Wₙ. If the input DC level is larger than the optimum point (corresponding to Vₘ), the digital control enables more PMOS transistors such that the buffer's VTC shifts to the right. Similarly, if the input DC level is smaller than the optimal point, more NMOS transistors are enabled to shift the VTC towards the left.

The subsequent buffer 22 in Fig.4 is used because a large load needs to be driven. In its absence, the default pair of the tuneable buffer should be very large. This in turn warrants large sizes for additional transistors to alter the Wₚ/Wₙ significantly, leading to a larger overall buffer size. To summarize, the first buffer brings the low-input swing to rail-to-rail level and drives the relatively small subsequent buffer which drives the actual load (a power amplifier or divider for example).

Since the proposed structure avoids any passive components, it occupies a very small area and is aligned with the technology scaling. Moreover, the power consumption is reduced by avoiding driving the large parasitics associated with the decoupling capacitors. Also, noise feed-through from the bias resistor is absent, thereby allowing lower current consumption for a given phase noise requirement compared to the conventional approach.

The proposed buffer 21 requires a minimum setup of one default NMOS-PMOS transistor pair and an additional switchable NMOS-PMOS pair whose source terminals are connected to GND and VDD, respectively, via switches. The actual number of switchable NMOS-PMOS pairs required is determined by the range of VTC shift that is needed.

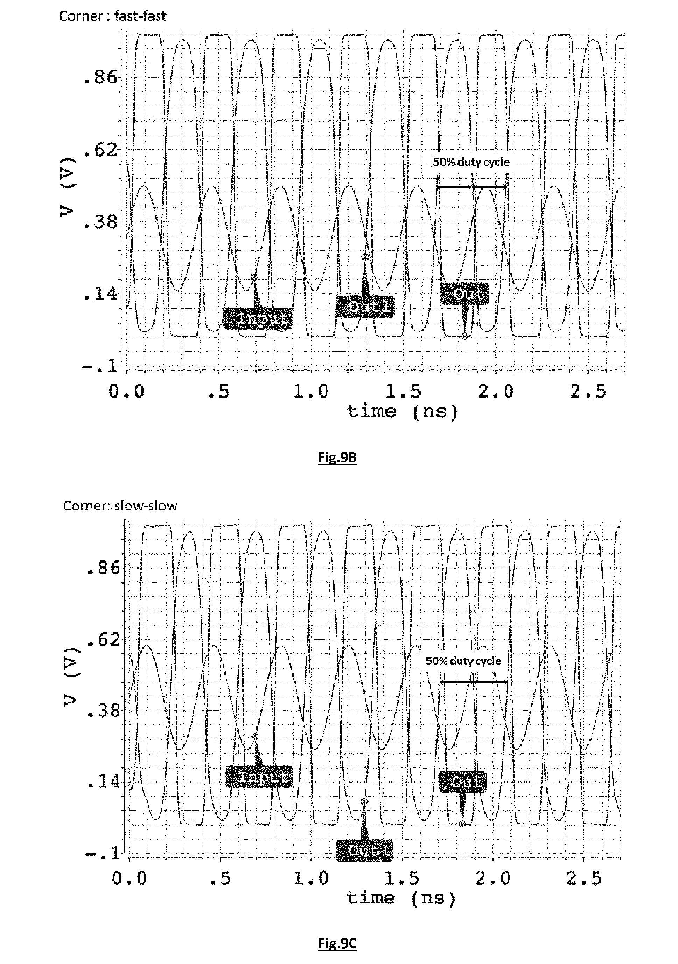

Fig.9 shows the transient simulation of the buffer shown in Fig.8 across process corners. The input (from the oscillator) and the output of the buffer 21 and buffer 22 are shown. The input DC level varies from 380mV for a typical corner to 325 mV for fast corner and 425 mV for slow corner. The buffer control is set in each case to operate close to the maximum sensitivity point. In the slow-corner (Fig.9C), since the input DC-level is higher, more PMOS transistors are enabled to shift the VTC and the maximum sensitivity point to right i.e., towards VDD. In this case the control word is e.g. 11010. Since the MSB is 1, all the NMOS switches (N1,N2,N3,N4) are off. The PMOS switches P2 and P4 are enabled resulting in a transistor ratio: (8Wₚ + 2Wₚ + 5Wₚ)/(5Wₙ) =3Wₚ/Wₙ. In the fast corner more, the input DC-level is lower and hence more NMOS transistors are turned ON to shift the VTC to left i.e., towards GND. In this case, the control word is 01101. Since the MSB is 0, all the PMOS switches (P1,P2,P3,P4) are off. The NMOS switches N1, N3, and N4 are enabled, resulting in a transistor ratio: 5Wₚ/(8Wₙ+ 4Wₙ +Wₙ+ 5Wₙ) =Wₚ/3.6Wₙ. It can be seen that the duty cycle in each case is around 50% (equal positive and negative pulse durations). Thus, this buffer can operate with any input DC-voltage between 325 mV to 425 mV. Hence, the proposed DC-coupled buffer can operate with low input-swings notwithstanding the process variations.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Buffering circuit (21) for buffering an oscillator signal, said buffering circuit comprising
- a plurality of PMOS and NMOS transistor pairs connected in parallel, each pair having connected gate terminals and connected drain terminals forming an inverter circuit, each pair arranged for receiving via a direct coupling an oscillator signal at its gate terminal, each pair further being connected with an additional PMOS and NMOS transistor (P1, N1, P2, N2)
- a control circuit (4) arranged for receiving an output signal output by said inverter circuits, for deriving information on the DC level of said output signal and for adjusting a voltage transfer curve expressing a relationship between a voltage at the input and output of said buffering circuit, by switching on or off said additional PMOS and NMOS transistors based on said derived information.

2. Buffering circuit (21) as in claim 1, wherein said control circuit (4) is arranged for deriving said information on said DC level by averaging said output signal.

3. Buffering circuit (21) as in claim 1 or 2, wherein said inverter circuit is implemented in CMOS.

4. Buffering circuit (21) wherein the transistor pairs of said plurality are sized such that they form binary weights.

5. Buffering circuit (21) wherein said control circuit is arranged for adjusting said DC level by generating code words.

6. Device (10) comprising an oscillator and a buffering circuit as in any of claims 1 to 5.

7. Device (10) as in claim 6, wherein said oscillator is a voltage controlled oscillator or a digitally controlled oscillator.

8. Device (10) as in claim 6 or 7, comprising a further buffer (22) arranged for receiving said output signal.

9. Device (10) as in any of claims 6 to 8, wherein said oscillator is part of a phase-locked loop.

10. Method for calibrating a buffering circuit, comprising the steps of
- applying via a direct coupling an oscillator signal to a circuit comprising a plurality of PMOS and NMOS transistor pairs connected in parallel, each pair having connected gate terminals and connected drain terminals forming an inverter circuit, each pair arranged for receiving said oscillator signal at its gate terminal, each pair further being connected with an additional PMOS and NMOS transistor (P1, N1, P2, N2),
- deriving information on the DC level of an output signal output by said inverter circuits, and
- adjusting a voltage transfer curve expressing a relationship between a voltage at the input and output of said buffering circuit, by switching on or off said additional PMOS and NMOS transistors based on said derived information.
